## Europäisches Patentamt

## European Patent Office

## Office européen des brevets

(19)

(11) Numéro de publication: **0 211 757**
**B1**

(12) **FASCICULE DE BREVET EUROPEEN**

(45) Date de publication du fascicule du brevet:
**12.09.90**

(21) Numéro de dépôt: **86401704.1**

(22) Date de dépôt: **30.07.86**

(51) Int. Cl.⁵: **H03M 5/14,** G11B 20/14,
H04L 25/49

(54) **Procédé de modulation en bande de base d'un signal de données, appareil de modulation et appareil de démodulation correspondants.**

(30) Priorité: **02.08.85 FR 8511864**

(43) Date de publication de la demande:
**25.02.87 Bulletin 87/9**

(45) Mention de la délivrance du brevet:
**12.09.90 Bulletin 90/37**

(84) Etats contractants désignés:
**AT BE CH DE GB IT LI LU NL SE**

(56) Documents cités:
EP-A- 0 013 990
DE-A- 2 853 559
FR-A- 2 438 388
FR-A- 2 438 391
GB-A- 2 067 055
GB-A- 2 078 060

JOURNAL OF THE AUDIO ENGINEERING SOCIETY,
vol. 31, no. 4, April 1983, pages 224-238, New York, US;
T.T. DOI: "Channel codings for digital audio
recordings"
IBM JOURNAL OF RESEARCH AND DEVELOPMENT,
vol. 19, no. 4, juillet 1975, pages 366-378, New York, US;
A.M. PATEL: "Zero-modulation encoding in magnetic
recording"
IEEE TRANSACTIONS ON COMMUNICATIONS, vol.

(73) Titulaire: Etablissement Public TELEDIFFUSION DE
FRANCE, 10, rue d'Oradour-sur-Glane, F-75732 Paris
Cédex 15(FR)

(72) Inventeur: Viallevieille, Alain, 7 Ter, rue Saint Charles,
F-78000 Versailles(FR)

(74) Mandataire: Mongrédien, André et al, c/o
BREVATOME 25, rue de Ponthieu, F-75008 Paris(FR)

(56) Documents cités: (suite)
COM-31, no. 1, janvier 1983, pages 105-110, IEEE, New
York, US; R.W. WOOD: "Further comments on the
characteristics of the Hedeman H-1, H-2, and
H-3 codes"
Dieter Thomsen, "Digitale Audiotechnik",
Franzis-Verlag München, 1983, pages 77-87

## Description

La présente invention a pour objets un procédé de modulation en bande de base d'un signal de données, un appareil de modulation et un appareil de démodulation correspondants. Elle s'applique notamment à l'enregistrement et à la reproduction magnétique de données numériques, par exemple de signaux audio.

Le procédé de l'invention repose sur une modulation (1,2), c'est-à-dire qu'il fait correspondre deux valeurs binaires à une valeur binaire initiale. Cette modulation est de type 3PM qui convertit toute suite de n bits de données en une suite de 2.n bits codés, représentés chacun par la présences ou l'absence d'une transition et dans laquelle deux bits codés consécutifs représentés par une transition sont séparés par au moins deux bits codés représentés par une absence de transition. En d'autres termes, si le signal de données est présenté à un modulateur à la cadence T, l'interfront minimum dans le signal modulé est égal à 1,5T.

On connaît déjà plusieurs procédés de modulation de type 3PM. Le premier d'entre eux, du point de vue historique, est décrit notamment dans l'article "A new look-ahead code for increased data density" de G.V. Jacoby paru dans IEEE Transactions on Magnetics, vol. Mag.13, n°5, sept 1977, p.1202-1204. Dans ce procédé de modulation, l'interfront maximal (paramètre qui donne une indication sur la possibilité à la démodulation de récupérer le signal d'horloge à partir du signal modulé) reçu est de 6T. Cette valeur est élevée et constitue un des inconvénients majeurs de ce procédé de modulation.

On connaît des procédés de modulation de type 3PM dans lesquels l'interfront maximal est moins grand. Dans le procédé de modulation dénommé HDM1, par exemple, l'interfront maximal est égal à 4,5T. Cet interfront commence toujours dans le signal modulé par une transition en début d'intervalle de bit et finit toujours par une transition en milieu d'intervalle de bit (Un intervalle de bit a une longueur T et est associé à une donnée binaire à coder ; la présence d'une transition pour représenter le premier bit codé de cette donnée binaire correspond à une transition en début d'intervalle de bit, la présence d'une transition pour représenter le deuxième bit codé à une transition en milieu d'intervalle de bit). Deux transitions consécutives séparées par un interfront maximal ayant chacune une position fixe (début ou milieu) dans un intervalle de bit, la détection d'une séquence comprenant un interfront maximal permet de synchroniser l'horloge de période T, déduite du signal modulé, sur le début des intervalles de bit. Cependant, ce procédé de modulation présente l'inconvénient qu'une telle séquence est rare; la synchronisation de l'horloge ne peut donc pas être vérifiée aussi souvent que l'on peut le souhaiter.

On connaît également un procédé de modulation de type 3PM dans lequel l'interfront maximal est égal à 4T. Ce procédé est dénommé HDM2. Dans ce procédé, l'interfront maximal commence toujours par une transition en milieu d'intervalle de bit et se termine de même. Mais, le procédé HDM2 présente le désavantage de ne pas créer une correspondance simple entre une suite de bits codés et une suite de bits de données. Par exemple, une séquence comprenant un interfront de longueur 3T dont la transition initiale a lieu en début d'intervalle de bit peut correspondre aussi bien à une suite de trois bits de données de valeur "1" qu'à une suite de trois bits de données de valeur "0". Le choix entre ces deux possibilités ne peut être fait qu'en fonction du contexte, c'est-à-dire en fonction des bits suivant ladite suite. La démodulation requiert donc une mémoire importante qui complique l'appareil de démodulation.

L'on peut également se reporter à l'état de la technique constitué par le document : Dieter Thomsen, "Digitale Audiotechnik", Franzis-Verlag München, 1983, pages 77 à 87.

La présente invention a pour objet un procédé de modulation palliant cet inconvénient sans affaiblir les autres caractéristiques de modulation tels que l'interfront minimum, l'interfront maximal ou la marge de phase. Le procédé de modulation de l'invention est intéressant en ce que chaque couple de deux transitions successives du signal modulé est décodable en une suite unique de bits de données consécutifs. Ceci permet notamment de réduire la mémoire requise pour la démodulation par rapport au procédé de modulation HDM2.

De manière précise, l'invention consiste à produire un signal modulé comprenant une suite d'intervalles de bit à une cadence T à partir d'un signal de données composé d'une succession de bits à la cadence T par un procédé de modulation dans lequel on marque normalement un bit de donnée d'un premier état logique , noté "0", par une transition en début d'un intervalle de bit et un bit de donnée du second état logique, noté "1", par une transition en milieu d'un intervalle de bit, et dans lequel, de manière caractéristique :

a) on marque un bit de valeur "0", s'il suit un bit non marqué de valeur "0" ou une séquence de trois bits consécutifs non marqués de valeur "1",

b) on marque un bit de valeur "1" s'il suit un bit de valeur "0" ou une séquence de trois bits consécutifs non marqués de valeur "1",

c) par exception aux règles précédentes, dans le cas où ces règles conduisent à marquer le premier bit d'une séquence, dite séquence particulière, composée de trois bits de valeur "1", suivis d'un bit de valeur "0", on code cette séquence particulière de la manière suivante:

c1) si le bit précédant ladite séquence particulière est un bit de valeur "0" marqué, seul le troisième bit de valeur "1" de ladite séquence particulière est marqué, ceci par une transition en milieu d'intervalle de bit,

2

EP 0 211 757 B1

c2) dans les autres cas, on marque le premier bit de valeur "1" et le bit de valeur "0" de ladite séquence particulière chacun par une transition en début d'intervalle de bit.

L'invention a également pour objet un appareil de modulation comprenant un générateur d'horloges délivrant un signal d'horloge H de période T dont les fronts montants coïncident avec le début des intervalles de bit du signal modulé et un signal d'horloge H' de période T/2 synchronisé sur le signal d'horloge H ; un convertisseur alimenté par le signal de données binaires et recevant le signal d'horloge H, ledit convertisseur délivrant deux signaux binaires $d_0$, $d_1$ notant respectivement les transitions en début et en milieu d'intervalle de bit ; et un circuit de sérialisation recevant les signaux $d_0$, $d_1$ et les signaux d'horloge H et H' et délivrant le signal modulé, ledit appareil étant caractérisé en ce que le convertisseur comprend :
- un convertisseur élémentaire comprenant un moyen de détection pour détecter et différencier les bits de valeur "0" marqués et non marqués, et un moyen de codage pour coder le bit du signal de données suivant un bit de valeur "0" détecté par le moyen de détection, ledit moyen de codage étant apte à coder ledit bit conformément au procédé,
- un circuit de transformation pour transformer la valeur d'un bit de valeur "1" en valeur "0", avant le codage dudit bit, lorsque l'une des conditions suivantes est réalisée :

a) ledit bit est le quatrième bit d'une séquence de quatre bits de valeur "1" dont seul le premier est marqué,
b) ledit bit est le deuxième bit de la séquence particulière et cette séquence suit un bit marqué de valeur "0",
c) ledit bit est le troisième bit de la séquence particulière et cette séquence suit un bit non marqué de valeur "0".

L'invention a enfin pour objet un appareil de démodulation pour démoduler un signal obtenu par le procédé de l'invention.

Cet appareil de démodulation comprend un circuit de restitution d'horloges recevant le signal modulé et produisant un signal d'horloge H de période T dont les fronts montants coïncident avec le début des intervalles de bit, et un signal d'horloge H' de période T/2 synchronisé sur le signal d'horloge H ; un circuit de désérialisation recevant le signal d'horloge H' et le signal modulé et délivrant un signal $S_0$ indiquant la présence d'une transition en début d'un intervalle de bit et un signal $S_1$ indiquant une transition en milieu d'un intervalle de bit ; et un convertisseur recevant les signaux délivrés par le circuit de désérialisation et le signal d'horloge H et produisant un signal de données binaires, ledit appareil étant caractérisé en ce que ledit convertisseur comprend :
- un convertisseur élémentaire pour délivrer un bit de donnée de valeur "0" lorsque le signal $S_0$ indique une transition en début d'intervalle de bit et un bit de donnée de valeur "1" lorsque le signal $S_1$ indique une transition en milieu d'intervalle de bit, et pour forcer à la valeur "0" chaque bit de donnée qui immédiatement précède un bit marqué,
- un circuit de transformation pour transformer l'état d'un bit de donnée de valeur "0" délivré par le convertisseur élémentaire en un bit de donnée de valeur "1" lorsque l'une des conditions suivantes est réalisée :

α) dans un signal modulé dont l'interfront est égal à 3,5T ou 4T, dans lequel ledit bit précède le bit associé à la transition finale de l'interfront et la transition initiale de l'interfront est en milieu de l'intervalle de bit, ledit bit est forcé à la valeur "1",
β) dans un signal modulé dont l'interfront est égal à 3T et dont la transition initiale est en début de l'intervalle de bit, les trois bits associés à cet interfront sont forcés à la valeur "1",
γ) dans un signal modulé dont l'interfront est égal à 3,5T et dont la transition initiale est en début de l'intervalle de bit, les deux bits associés aux intervalles de bits consécutifs audit intervalle de bit sont forcés à la valeur "1".

Les caractéristiques et avantages de l'invention ressortiront mieux de la description qui va suivre donnée à titre illustratif mais non limitatif, en référence aux dessins annexés, sur lesquels :

- les figures 1a à 1i représentent les règles de modulation conforme au procédé de l'invention,
- les figures 2a à 2g montrent que chaque couple de transition distantes d'une longueur comprise entre 1,5T et 4T, et dont la transition initiale a une position donnée (début ou milieu d'intervalle de bit) définit de manière univoque une suite de bits de données,
- la figure 3 illustre la structure de l'appareil de modulation de l'invention,
- la figure 4 illustre un mode de réalisation du convertisseur élémentaire du convertisseur de l'appareil de modulation de l'invention,
- la figure 5 illustre un mode de réalisation du convertisseur et du circuit de sérialisation de l'appareil de modulation de l'invention,
- la figure 6 représente un moyen d'insertion d'un mot de synchronisation qui peut être ajouté à l'appareil de modulation de l'invention,

3

- la figure 7 est un chronogramme des principaux signaux associés au circuit de la figure 6,
- la figure 8 illustre la structure de l'appareil de démodulation de l'invention, et
- la figure 9 représente un mode de réalisation de circuit de désérialisation et du convertisseur de l'appareil de démodulation de l'invention.

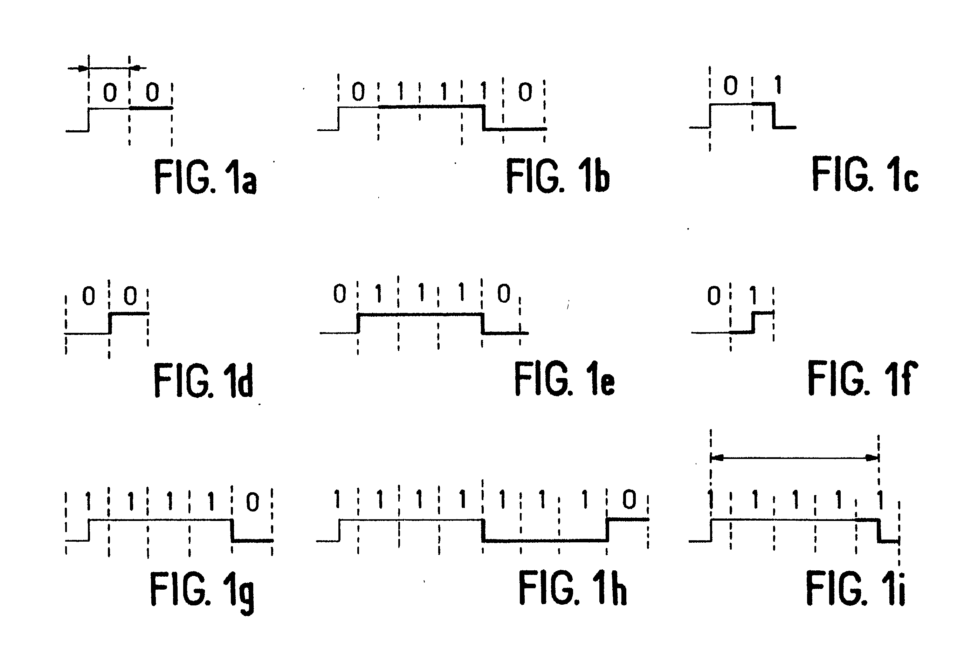

On va maintenant décrire le procédé de modulation de l'invention en relation avec les figures 1a à 1i. Chacune de ces figures comprend une suite de données binaires et le signal modulé correspondant. Chaque suite se compose de deux parties consécutives.

Sur les figures 1a, 1b et 1c, la première partie est un bit marqué de valeur "0" ; sur les figures 1d, 1e et 1f, c'est un bit non marqué de valeur "0", et sur les figures 1g, 1h et 1i, c'est une suite composée de quatre bits de valeur "1" dont seul le premier est marqué. La deuxième partie est un bit de valeur "0" sur les figures 1a, 1d et 1g ; une suite composée de trois bits de valeur "1" et d'un bit de valeur "0" sur les figures 1b, 1e et 1h ; et une suite de quatre bits commençant par un bit de valeur "1" mais différente de la suite précédente sur les figures 1c, 1f et 1i.

On rappelle que les règles de codage sont les suivantes :

a) on marque un bit de valeur "0" s'il suit un bit non marqué de valeur "0" ou une séquence de trois bits consécutifs non marqués de valeur "1". Ces deux cas sont illustrés respectivement par les figures 1d et 1g ; le cas contraire, où le bit de valeur "0" suit un bit de valeur "0" marqué et n'est donc pas marqué, est illustré par la figure 1a,

b) on marque un bit de valeur "1" s'il suit un bit de valeur "0" ou une séquence de trois bits consécutifs non marqués de valeur "1". Le premier cas correspond aux figures 1c et 1f respectivement lorsque le bit de valeur "0" est marqué et lorsqu'il n'est pas marqué. Le deuxième cas est représenté sur la figure 1i ; c'est le cas qui fait apparaître l'interfront maximal de longueur 4T.

c) dans le cas où les règles a) et b) conduisent à marquer le premier bit d'une séquence, dite séquence particulière, composée de trois bits de valeur "1" suivis d'un bit de valeur "0", on code cette séquence particulière en bloc, par exception auxdites règles a) et b), de la manière suivante :

c1) si le bit précédent ladite séquence particulière est un bit marqué de valeur "0", seul le troisième bit de valeur (1) de cette séquence particulière est marqué, et il l'est par une transition en milieu d'intervalle de bit. Ce cas est illustré sur la figure 1b.

c2) dans les autres cas, on marque le premier bit de valeur "1" et le bit de valeur "0" de ladite séquence particulière chacun par une transition en début d'intervalle de bit. Ce cas est représenté sur les figures 1e et 1h respectivement lorsque ladite séquence particulière est précédé d'un bit de valeur "0" non marqué et lorsque ladite séquence particulière est précédé d'une suite de trois bits consécutifs non marqués de valeur "1". Le cas c2) est le seul dans lequel un bit de valeur "1" est marqué par une transition en début d'intervalle de bit.

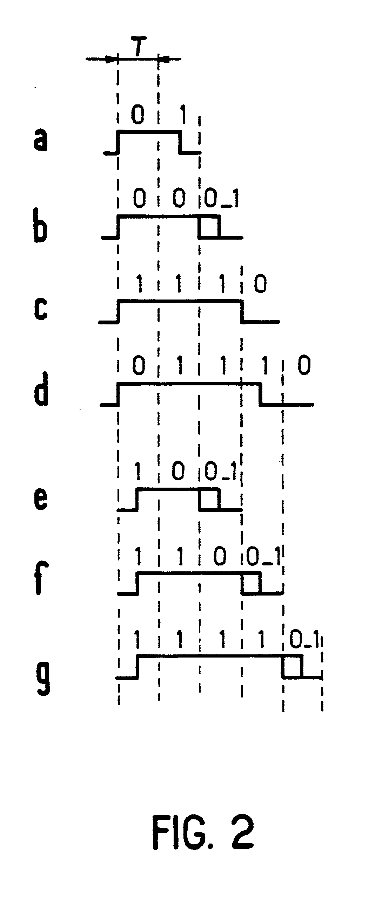

Le signal modulé obtenu selon le procédé de modulation de l'invention présente une correspondance simple avec le signal de données, à la différence du signal modulé obtenu par le procédé de modulation connu HDM2. En effet, comme le montrent les figures 2a et 2f, la connaissance de la distance entre deux transitions consécutives et de la position de la première de ces transitions (début ou milieu d'intervalle de bit) détermine sans ambiguïté une suite de bits de données.

Sur les figures 2a, 2b, 2c et 2d, la première transition est située en début d'intervalle de bit ; sur les figures 2e, 2f et 2g, elle est située en milieu d'intervalle de bit. La figure 2c, où la distance entre les transitions est égale à 3T correspond à la séquence particulière de trois bits consécutifs de valeur "1" suivis d'un bit de valeur "0" codés suivant la règle c2).

La figure 2a illustre le cas où l'intervalle entre deux transitions consécutives est égal à 1,5T, la figure 2b les cas 2T et 2,5T, la figure 2d le cas 3,5T, la figure 2e les cas 1,5T et 2T, la figure 2f les cas 2,5T et 3T, et la figure 2g les cas 3,5T et 4T.

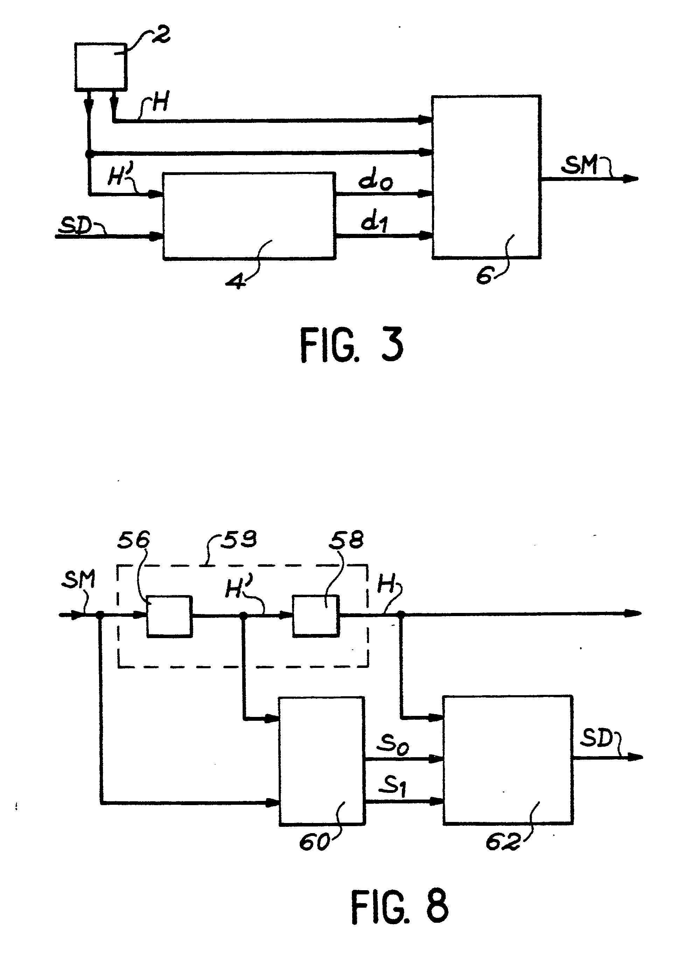

On a représenté schématiquement sur la figure 3 un appareil de modulation pour la mise en oeuvre du procédé de modulation de l'invention. Cet appareil comprend un générateur d'horloges 2, un convertisseur 4 et un circuit de sérialisation 6. Le générateur d'horloges 2 produit un signal d'horloge H de période T et un signal d'horloge H' de période T/2, ces deux signaux étant synchronises entre eux et avec le signal de données à coder. Ce dernier est appliqué sur une entrée du convertisseur 4 qui reçoit également le signal d'horloge H. Il délivre deux signaux $d_0$ et $d_1$ indiquant respectivement la présence ou l'absence d'une transition en début et en milieu d'un intervalle de bit en fonction du bit de donnée à coder et éventuellement de bits de données antérieurs. Les signaux $d_0$ et $d_1$ et les signaux d'horloges H et H' sont appliqués sur des entrées du circuit de sérialisation 6 qui délivre le signal modulé SM correspondant au signal de données reçu par le convertisseur 4.

Le convertisseur 4 est composé de deux éléments : un convertisseur élémentaire et un circuit de transformation. Le convertisseur élémentaire est conçu pour détecter et différencier les bits marqués et non marqués de valeur "0" et pour coder le bit suivant ce bit détecté. Le circuit de transformation force, dans certains cas, à "0" la valeur d'un bit de valeur "1" avant le codage dudit bit. Ceci permet au convertisseur élémentaire de coder le signal de donnée dans son ensemble.

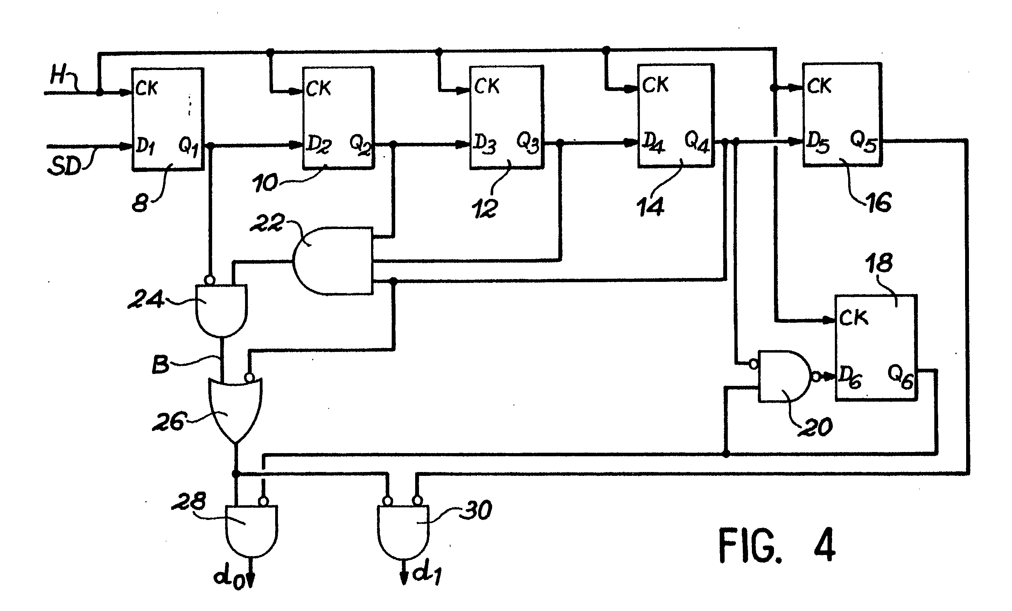

Un mode de réalisation du convertisseur élémentaire est représenté sur la figure 4. Il comprend un ensemble de cinq bascules de type D 8, 10, 12, 14 et 16 formant un registre à décalage. Les entrées et les sorties de données de ces bascules sont notées respectivement $D_i$ et $Q_i$ où $1 \le i \le 5$ est le rang des bascules. Le convertisseur élémentaire comprend également une bascule de type D 18 ; l'entrée et la sortie de donnée de cette bascule sont notées respectivement $D_6$ et $Q_6$. Chaque bascule reçoit le signal d'horloge H sur son entrée d'horloge CK. Le bit en cours de codage est le bit présent en $Q_4$.

Le convertisseur élémentaire comprend enfin un ensemble de portes logiques ; une porte NON-ET 20 dont une entrée inverseuse est reliée à la sortie $Q_4$ et une entrée non inverseuse à la sortie $Q_6$, et dont la sortie est reliée à l'entrée $D_6$ ; une porte ET 22 à trois entrées reliées aux sorties $Q_2$, $Q_3$ et $Q_4$ ; une porte ET 24 dont une entrée inverseuse est reliée à la sortie $Q_1$ et une entrée non inverseuse à la sortie de la porte ET 22 ; une porte OU 26 dont une entrée inverseuse est reliée à la sortie $Q_4$ et une entrée non inverseuse à la sortie de la porte ET 24 ; une porte ET 28 dont une entrée inverseuse est reliée à la sortie $Q_6$ et une entrée non inverseuse à la sortie de la porte OU 26 ; et une porte ET 30 à entrées inverseuses reliées à la sortie $Q_5$ et à la sortie de la porte OU 26. Les portes 28 et 30 délivrent les signaux $d_0$ et $d_1$ indiquant la présence en l'absence de transition respectivement en début ou en milieu d'intervalle de bit pour le bit en cours de codage.

Le moyen de détection et de différenciation est constitué des éléments 16, 18 et 20. La détection des bits de valeur "0" est assurée par la bascule 16. La présence d'un "0" en $Q_5$ est indiquée par l'état bas de cette sortie $Q_5$. La différenciation des bits de valeur "0" se fait par un circuit de comptage composé de la bascule 18 et de la porte NON-ET 20 ; en effet, les bits de valeur "0" marqués sont les bits de valeur "0" de rang pair. La sortie $Q_6$ peut prendre deux valeurs : $Q_6$="0" indique la présence d'une bit de valeur "0" non marqué en $Q_5$ ("0" de rang impair, on a alors $Q_5$="0"), $Q_6$="1" indique la présence d'un "0" marqué si $Q_5$="0" ("0" de rang pair).

La détection des séquences "1110" lorsqu'on a un bit de valeur "0" marqué ou non marqué en $Q_5$ est assurée par les portes 22 et 24 en considérant les sorties $Q_1$ à $Q_4$ du registre à décalage. Le signal B de sortie de la porte 24 est égal à $\overline{Q}_1.Q_2.Q_3.Q_4$. Il est égal à "1" si la séquence "1110" est détectée, à "0" dans le cas contraire.

Les signaux $d_0$ et $d_1$ ont leur état qui correspond au marquage ou à l'absence de marquage que devra avoir le bit présent en $Q_4$. Ils sont définis par :

$$d_0 = \overline{Q}_6 . (\overline{Q}_4 + \overline{Q}_1 . Q_2 . Q_3 . Q_4)$$

$$d_1 = \overline{Q}_5 . (\overline{Q_4 . \overline{Q}_1 . Q_2 . Q_3 . Q_4}) = \overline{Q}_5 . (\overline{\overline{Q}_4 + \overline{Q}_1 . Q_2 . Q_3 . Q_4})$$

Le convertisseur élémentaire permet de coder les cas correspondant aux figures 1a, 1c, 1d, 1f. Les cas des figures 1b et 1e sont partiellement couverts. La prise en compte des autres règles de modulation (figures 1g, 1h, 1i et dernière transition sur les figures 1b et 1e) est réalisé par le convertisseur élémentaire grâce à l'action du circuit de transformation qui force, avant le codage des bits de données, certains bits de données de valeur "1" à la valeur "0".

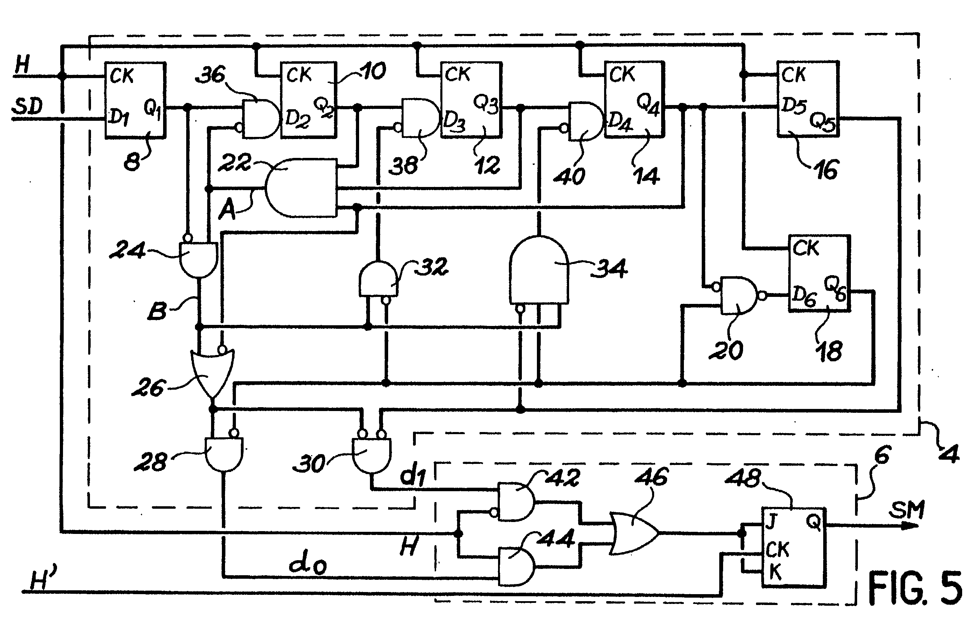

On a représenté sur la figure 5 un mode de réalisation du convertisseur 4 et du circuit de sérialisation 6. Ce convertisseur comprend un convertisseur élémentaire identique à celui représenté sur la figure 4 et un circuit de transformation composé d'un ensemble de portes logiques pour forcer l'une des entrées $D_2$, $D_3$ ou $D_4$ à la valeur "0" en fonction des états des sorties $Q_1$ à $Q_6$. Ceci est nécessaire pour marquer tous les bits qui doivent l'être car les signaux $d_0$ et $d_1$ ne peuvent passer à l'état haut que lorsque $Q_5$="0".

La valeur "0" qui est forcée sur l'une des entrées $D_2$, $D_3$ ou $D_4$ est vue par le convertisseur élémentaire comme un bit de valeur "0" non marqué en $Q_6$ (on vérifiera plus loin que ce bit de valeur "0" suit toujours un bit de valeur "1") et le bit qui est alors en $Q_4$ est marqué selon les règles de fonctionnement du convertisseur élémentaire. En particulier, si à cet instant là on a un bit de valeur "0" en $Q_4$, pendant la période d'horloge suivante, ce bit de valeur "0" sera considéré comme un "0" marqué.

Le circuit de transformation se compose d'une porte ET 32 dont une entrée inverseuse est reliée à la sortie $Q_6$ et une entrée non inverseus à la sortie de la porte ET 24 ; une porte ET 34 dont une entrée inverseuse est reliée à la sortie $Q_5$ et deux entrées non inverseuses à la sortie $Q_6$ et à la sortie de la porte ET 24 ; une porte ET 36 dont une entrée inverseuse est reliée à la sortie de la porte ET 22 et une entrée non inverseuse à la sortie $Q_1$, et dont la sortie est reliée à l'entrée $D_2$ ; une porte ET 38 dont une entrée inverseuse est reliée à la sortie de la porte ET 32 et une entrée non inverseuse à la sortie $Q_2$, et dont la sortie est reliée à l'entrée $D_3$ ; et une porte ET 40 dont une entrée inverseuse est reliée à la sortie de la porte ET 34 et une entrée non inverseuse à la sortie $Q_3$, et dont la sortie est reliée à l'entrée $Q_4$.

Le circuit de transformation fonctionne de la manière suivante. Lors de l'apparition d'une séquence "1111" on a $Q_1=Q_2=Q_3=Q_4$="1". La sortie $Q_5$ est égale à "0" (sinon une des entrées du registre à décalage aurait été forcée à la valeur "0"). On marque le bit présent en $Q_4$ selon les règles de fonctionnement du convertisseur élémentaire ($d_0$=0, $d_1$=1) et on force l'entrée $D_2$ à la valeur "0". Dans les autres cas on a $D_2=Q_1$. Lorsque le bit forcé à la valeur "0" en $D_2$ arrive en $Q_5$ il est considéré comme un "0" non marqué (il suit un "1", c'est donc un "0" de rang impair). Le bit suivant est alors marqué par le convertisseur élémentaire selon ses règles de fonctionnement normales. De cette façon, le marquage des bits dans les cas des figures 1g, 1h et 1i se ramène au marquage des bits dans les cas des figures 1d, 1e et 1f.

Au plan de la réalisation pratique, on note que :

$$D_2 = Q_1 \cdot (\overline{\overline{Q_1} \cdot Q_2 \cdot Q_3 \cdot Q_4}) = Q_1 \cdot (\overline{Q_2 \cdot Q_3 \cdot Q_4})$$

Il reste alors pour les cas des figures 1b et 1e, à assurer la dernière transition.

Lors de l'apparition de la séquence "1110" après un bit de valeur "0" non marqué (figure 1e), on a $Q_6$="0" et $Q_1$="0", $Q_2=Q_3=Q_4$="1". On marque le bit en $Q_4$ selon les règles de fonctionnement du convertisseur élémentaire et on force l'entrée $D_3$ à la valeur "0". Dans les autres cas, on a $D_3=Q_2$.

Lorsque ce bit forcé à la valeur "0" arrive en $Q_5$, il est considéré comme un bit de valeur "0" non marqué parce qu'il suit un bit de valeur "1" (c'est un bit de valeur "0" de rang impair). Le bit de valeur "0" de la séquence "1110" est alors marqué par le convertisseur élémentaire par une transition en début de l'intervalle de bit ($d_0$=1, $d_1$=0) et est considéré ensuite comme une bit de valeur "0" marqué.

L'état de l'entrée $D_3$ est tel que :

$$D_3 = Q_2 \cdot (\overline{\overline{Q_1} \cdot Q_2 \cdot Q_3 \cdot Q_4 \cdot \overline{Q_6}})$$

Lors de l'apparition de la séquence "1110" après un bit de valeur "0" marqué (figure 1b), on a : $Q_6$ = "1", $Q_5$ = "0", $Q_1$ = "0", $Q_2 = Q_3 = Q_4$ = "1".

On ne marque pas le bit en $Q_4$ (règles normales) et on force l'entrée $D_4$ à la valeur "0". Dans les autres cas on a $D_4 = Q_3$.

Lorsque ce bit forcé à la valeur "0" arrive en $Q_5$, il est considéré comme un bit de valeur "0" non marqué parce qu'il suit un bit de valeur "1". Le dernier bit de valeur "1" de la séquence "1110" est alors marqué par un saut de phase en milieu de l'intervalle de bit par le convertisseur élémentaire ($d_0$ = 0, $d_1$ = 1). Le bit de valeur "0" de cette séquence est considéré ensuite comme un bit de valeur "0" non marqué.

L'état de $D_4$ est tel que :

$$D_4 = Q_3 \cdot (\overline{\overline{Q_1} \cdot Q_2 \cdot Q_3 \cdot Q_4 \cdot \overline{Q_5} \cdot Q_6})$$

En résumé, le fonctionnement du convertisseur est défini, à partir des sorties $Q_1$, $Q_2$, $Q_3$, $Q_4$ $Q_5$ et de la sortie $Q_6$ de comptage des bits de valeur "0", par les équations logiques suivantes :

$$d_0 = (\overline{Q_1} \cdot Q_2 \cdot Q_3 \cdot Q_4 + \overline{Q_4}) \cdot \overline{Q_6} = (B + \overline{Q_4}) \cdot \overline{Q_6}$$

$$d_1 = (\overline{\overline{Q_1} \cdot Q_2 \cdot Q_3 \cdot Q_4} \cdot Q_4) \cdot \overline{Q_5} = (B + \overline{Q_4}) \cdot \overline{Q_5}$$

$$D_2 = Q_1 \cdot (\overline{Q_2 \cdot Q_3 \cdot Q_4}) = Q_1 \cdot \overline{A}$$

$$D_3 = Q_2 \cdot (\overline{\overline{Q_1} \cdot Q_2 \cdot Q_3 \cdot Q_4 \cdot \overline{Q_6}}) = Q_2 \cdot (\overline{B \cdot \overline{Q_6}})$$

$$D_4 = Q_3 \cdot (\overline{\overline{Q_1} \cdot Q_2 \cdot Q_3 \cdot Q_4 \cdot \overline{Q_5} \cdot Q_6}) = Q_3 \cdot (\overline{B \cdot \overline{Q_5} \cdot Q_6})$$

$$\text{avec } A = Q_2 \cdot Q_3 \cdot Q_4 \text{ et } B = \overline{Q_1} \cdot A$$

Le signal modulé est élaboré par le circuit de sérialisation 6 à partir des signaux $d_0$ et $d_1$ et des signaux d'horloge H et H'. Dans le mode de réalisation représenté sur la figure 5, ce circuit de sérialisation comprend une porte ET 42 dont une entrée non inverseuse reçoit le signal $d_1$ et une entrée inverseuse le signal d'horloge H ; une porte ET 44 dont les entrées reçoivent les signaux $d_0$ et H ; une porte OU 46 dont les entrées sont reliées aux sorties des portes ET 42 et 44 ; et une bascule de type J-K 48 recevant sur ses entrées J et K le signal délivré par la porte OU 46 et sur son entrée d'horloge CK le signal d'horloge H'. Le signal modulé est délivré par la sortie de données Q de la bascule 48.

Le convertisseur qui vient d'être décrit permet l'émission d'un signal de données modulé suivant le procédé de l'invention. Il est souvent utile de pouvoir ajouter aux données du signal modulé des mots particuliers, tels que des mots de synchronisation de trame, afin de repérer aisément, à la réception, des instants précis dans le train binaire reçu. Comme le montrent les figures 2a à 2g, la distance maximale entre deux transitions consécutives, qui est égale à 4T, n'intervient qu'entre des transitions situées en milieu d'un intervalle de bit. Ceci permet d'identifier le début et le milieu de ces intervalles de bit. On peut donc représenter un mot de synchronisation par une distance entre transitions égale à 4T, ces transitions intervenant en début d'un intervalle de bit ; on peut aussi représenter ce mot de synchronisation par toute distance entre transitions supérieure à 4T.

Pour la simplicité des circuits d'insertion et d'utilisation du mot de synchronisation, il est avantageux d'utiliser un mot de synchronisation présentant une distance entre deux transitions en milieu d'intervalle de bit égale à 5T.

Une réalisation consiste à introduire simultanément un mot de 8 bits sur l'entrée de données du convertisseur et une information de synchronisation SY sur une entrée de synchronisation. Ce mot de 8 bits doit permettre de s'assurer de la présence des transitions toujours au même endroit quel que soit le contexte dans lequel il arrive. Cette condition impose qu'il commence et finisse par un bit de valeur "0". Ces deux bits de valeur "0" encadrent six bits de valeur "1" consécutifs.

Sur l'entrée de synchronisation, on envoie le signal SY qui interdit le changement d'état qui, d'après les règles de modulation, aurait lieu normalement sur le cinquième bit de valeur "1" de la séquence.

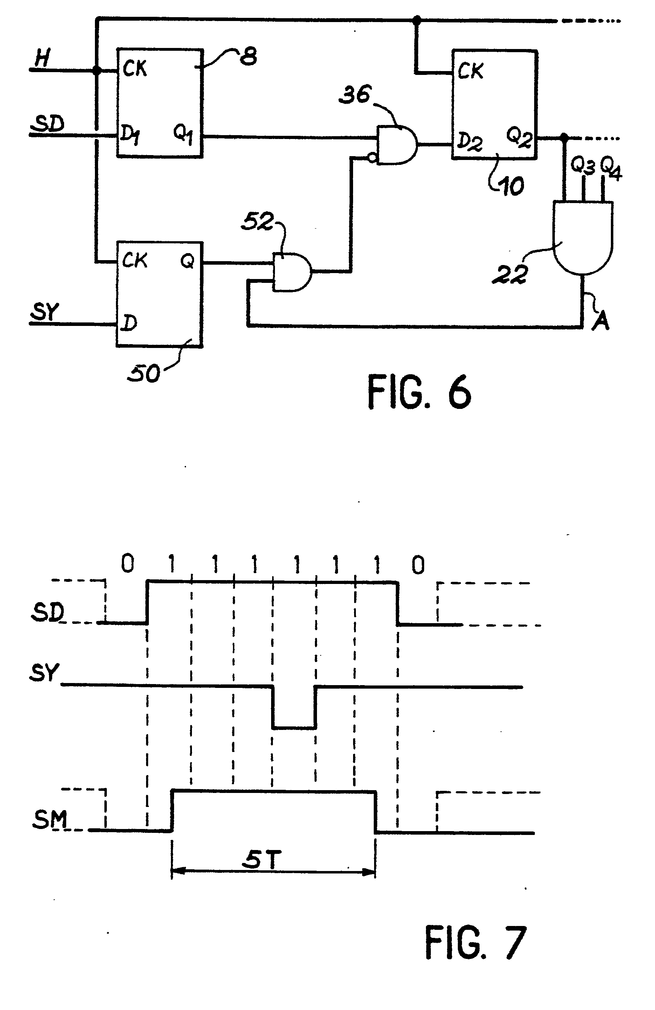

Un mode de réalisation de ce moyen d'insertion d'un mot de synchronisation est représenté sur la figure 6 en relation avec les éléments 8,10,22 et 36 du convertisseur élémentaire. Ce moyen d'insertion comprend une bascule de type D 50 dont l'entrée de données D reçoit le signal de synchronisation SY et l'entrée d'horloge le signal d'horloge H, une porte ET 52 dont les entrées sont reliées à la sortie de données Q de la bascule 50 et à la sortie de la porte ET 22, et dont la sortie est reliée à l'entrée inverseuse de la porte ET 36.

Le chronogramme de la figure 7 montre le signal de données SD appliquée sur l'entrée $D_1$. Ce signal représente le mot de synchronisation "01111110" en modulation NRZ. Le signal modulé SM délivré par le circuit de sérialisation est représenté en correspondance. Il comprend deux transitions situées en milieu des intervalles de bit des premier et dernier bits de valeur "1" du mot de synchronisation ; ces transitions sont distantes de 5T. Le signal de synchronisation SY est prévu pour interdire l'apparition d'une transition sur le cinquième bit de valeur "1" du mot de synchronisation. Ce signal de synchronisation est produit par un moyen de commande disposé en amont du convertisseur en même temps que le mot de synchronisation est appliqué sur l'entrée de données du convertisseur.

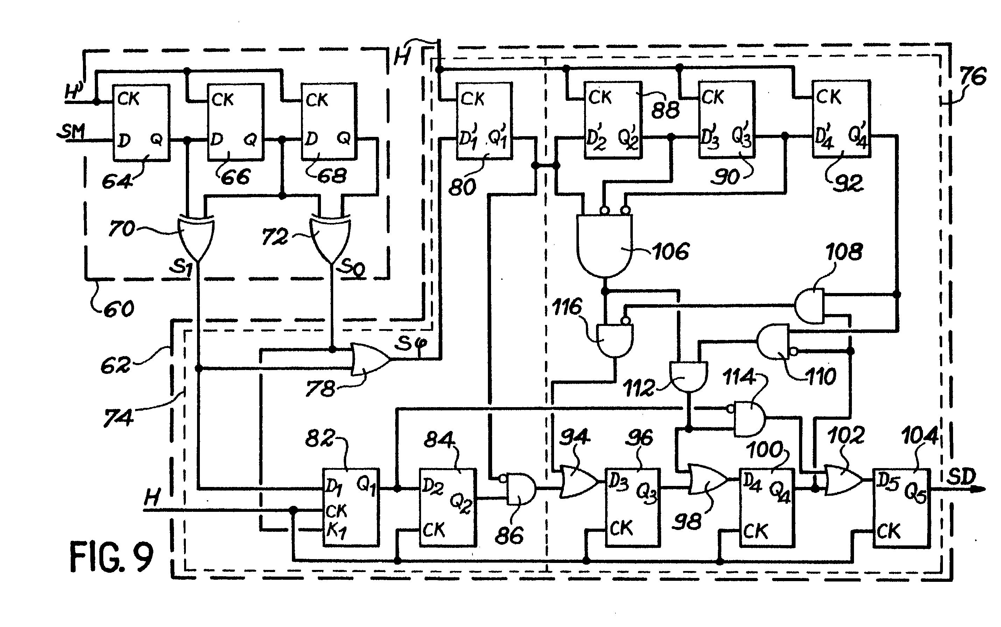

On va maintenant décrire en référence à la figure 8 un appareil de démodulation pour reproduire le signal de données codé à l'émission à partir du signal reçu modulé suivant le procédé de l'invention. Cet appareil de démodulation comprend trois éléments : un circuit de restitution d'horloges 59, un circuit de désérialisation 60 et un convertisseur 62.

Le circuit de restitution d'horloges 59 est de type classique. Il produit le signal d'horloge H' de fréquence 2/T, double du débit des bits de données à l'émission à partir du signal modulé SM, par un circuit 56 qui peut être par exemple une boucle à verrouillage de phase. Ce signal d'horloge H', dont les front descendants coïncident par exemple avec les transitions du signal modulé, alimente un diviseur de fréquence 58, élément du circuit de restitution d'horloges 59, qui délivre un signal d'horloge H de fréquence 1/T par division de fréquence du signal d'horloge H'.

Le diviseur de fréquence 58 comprend de manière classique une entrée de commande (non représentée) pour permettre une inversion de phase du signal d'horloge H afin que se fronts montants coïncident avec le début des intervalles de bit du signal de données SD. La phase exacte du signal d'horloge H est restituée avec précision en considérant les distances entre deux transition successives et en détectant les distances égales à 4T (figure 1i) ou à 5T pour les mots de synchronisation. On sait que ces fronts sont liés à des transitions en milieu de l'intervalle de bit et apparaissent lorsqu'on a au moins cinq bits de valeur "1" consécutifs.

L'appareil de démodulation comprend enfin un circuit de désérialisation 60 qui reçoit le signal modulé SM et le signal d'horloge H' et qui délivre deux signaux $S_0$ et $S_1$ indiquant la présence ou l'absence de transitions respectivement en début ou en milieu d'intervalle de bit. Ces deux signaux sont appliqués avec le signal d'horloge H sur des entrées du convertisseur 62 qui délivre le signal de données SD codé à l'émission.

La figure 9 illustre un mode de réalisation du circuit de désérialisation et du convertisseur de l'appareil de démodulation.

Le circuit de désérialisation 60 se compose de trois bascules de type D 64, 66 et 68 horlogées par le signal d'horloge H' et formant un registre à décalage, d'une porte OU-EXCLUSIF 70 dont les entrées sont reliées aux sorties de données Q des bascules 64 et 66 et d'une porte OU-EXCLUSIF 72 dont les entrées sont reliées aux sorties de données Q des bascules 66 et 68. Les portes 70 et 72 délivrent les signaux $S_1$ et $S_0$ indiquant respectivement les transitions en milieu et en début d'intervalle de bit ; ces signaux sont associés au signal d'horloge H.

Lorsqu'on connaît la position de deux transitions successives, le procédé de modulation utilisé permet dans tous les cas de décoder les bits compris entre le bit associé à la première transition (inclus) et le bit associé à la dernière transition (exclu) (cf figures 2a à 2f). Le convertisseur fonctionne en repérant la position de la première transition et en mesurant la distance qui sépare cette première transition de la suivant.

Le convertisseur 62 se divise en deux parties :
- la première partie est constituée par un convertisseur élémentaire 74 qui s'intéresse à la position des transitions dans l'intervalle de bit,
- la deuxième partie est constituée par une circuit 76 de transformation du train binaire qui sort du convertisseur pour le transformer en fonction de la distance entre les transitions.

Le convertisseur élémentaire comprend une porte OU 78 recevant les signaux $S_0$ et $S_1$ et délivrant un signal $S_\phi$ indicateur de transitions, une bascule de type D 80 dont l'entrée de données $D'_1$ est reliée à la sortie de la porte OU 78, une bascule J-K 82 dont les entrées $J_1$ et $K_1$ reçoivent respectivement les signaux $S_1$ et $S_0$, une bascule de type D 84 dont l'entrée de données $D_2$ est reliée à la sortie de données $Q_1$ de la bascule 82, et une porte ET 86 ayant une entrée inverseuse reliée à la sortie $Q'_1$ et une entrée non inverseuse reliée à la sortie $Q_2$, la sortie de cette porte ET 86 constituant la sortie de données du convertisseur élémentaire. Toutes les bascules sont horlogées par le signal d'horloge H.

Le convertisseur élémentaire 74 fonctionne selon deux régles de base :
Quand on a une transition ($S_\phi$ = 1) :
- Le bit associé à la transition et les suivants prennent la valeur "1" si $S_1$="1" et $S_0$="0" (saut en milieu d'intervalle de bit) et la valeur "0" si $S_1$="0" et $S_0$="1" (saut en début d'intervalle de bit).
- La valeur du bit qui précède le bit associé à la transition est mise à "0".

Ces deux règles qui décrivent le fonctionnement du convertisseur élémentaire ne tiennent pas compte du décodage de trois séquences particulières dans l'ensemble des séquences possibles. Le convertisseur élémentaire ne permet pas de décoder :

α) Les séquences de plusieurs bits de valeur "1" consécutifs qui conduisent à une distance entre transitions de 3,5T ou 4T.
β) Les séquences "1110" qui conduisent à une distance entre transitions de 3T.
γ) Les séquences "1110" qui conduisent à une distance entre transitions de 3,5T.

Ces séquences sont prises en compte par le circuit de transformation.
Revenons sur le convertisseur élémentaire. Son fonctionnement est le suivant. La sortie $Q'_1$ indique si il y a eu une transition et la sortie $Q_1$ donne la nature de cette transition. On a $Q_1$="1" si lors du front montant de l'horloge H on avait $S_1$="1" et $S_0$="0", et $Q_1$="0" si lors du front montant de l'horloge H on avait $S_1$="0" et $S_0$="1". Quand $S_1$=$S_0$="0", la sortie $Q_1$ ne change pas d'état lors des changements d'états de l'horloge H.

Le convertisseur élémentaire force aussi la valeur du bit qui précède le bit associé à la transition à "0" lorsqu'il y a une transition et ne change pas sa valeur dans les autres cas. Nous avons alors en sortie de la porte ET 86 le signal $\overline{Q'_1}.Q_2$.

Le circuit de transformation 76 qui permet le décodage des séquences des cas α), β), et γ) comprend les éléments suivants :
. un ensemble de trois bascules D 88, 90 et 92 disposées en série et formant un registre à décalage à 4 étages avec la bascule 80 du convertisseur élémentaire. Les entrées de ces trois bascules sont notées respectivement $D'_2$, $D'_3$ et $D'_4$ et les sorties $Q'_2$, $Q'_3$ et $Q'_4$,
. trois ensembles en série composés chacun d'une porte OU 94, 98, 102 et d'une bascule de type D 96, 100, 104. La sortie de chaque porte OU est reliée à l'entrée de données $D_3$, $D_4$, $D_5$ de la bascule associée ; les sorties $Q_3$ et $Q_4$ des bascules 96 et 98 sont reliées respectivement à une entrée des portes OU 98 et 102 ; la sortie de la porte ET 86 (sortie du convertisseur élémentaire) est reliée à une entrée de la porte OU 94 ; la sortie $Q_5$ de la bascule 104 délivre le signal de données SD démodulé sous forme NRZ,
. un ensemble de portes logiques : une porte ET 106 dont deux entrées inverseuses sont reliées aux sorties $Q'_2$ et $Q'_3$ et une entrée non inverseuse à la sortie $Q'_1$ ; une porte ET 108 dont les entrées sont reliées aux sorties $Q_4$ et $Q'_4$ ; une porte ET 110 dont une entrée inverseuse est reliée à la sortie $Q_4$ et une entrée non inverseuse à la sortie $Q'_4$ ; une porte ET 112 dont les entrées sont reliées aux sorties des portes ET 106 et 110 ; une porte ET 114 dont une entrée inverseuse est reliée à la sortie $Q_1$ et l'une entrée non inverseus à la sortie de la porte ET 112 ; et une porte ET 116 dont une entrée inverseuse est reliée à la sortie de la porte ET 108 et une entrée non inverseuse à la sortie de la porte ET 106 ; les sorties des portes ET 116, 112 et 114 étant appliquées respectivement sur une entrée des portes OU 94, 98 et 102.

Le circuit de transformation force à la valeur "1" certains bits de valeur "0" qui sortent du convertisseur élémentaire lors de l'apparition des trois cas précédemment décrits :

α) Lors de l'apparition d'une distance 3,5T ou 4T entre front, la valeur du bit précédant la dernière transition est maintenue à "1" si le changement d'état précédent du code était une transition en milieu de l'intervalle bit.

β) Lors de l'apparition d'une séquence de longueur 3T associée à des transitions en début de l'intervalle de bit, les trois bits associés à la séquence sont forcés à la valeur "1".

γ) Lors de l'apparition d'une séquence de longueur 3,5T associé à une transition en début de l'intervalle de bit pour le premier bit de la séquence, les deuxième et troisième bits de la séquence sont forcés à la valeur "1".

Le circuit de transformation du train binaire délivré par le convertisseur élémentaire tient compte des sorties $Q'_1$ à $Q'_4$ et $Q_1$ à $Q_5$ des différentes bascules. Il associe aux trois cas particuliers précédemment décrits trois transformations du train binaire. Il faut d'abord identifier ces trois cas et ensuite agir sur les entrées $D_3$, $D_4$ et $D_5$ du registre à décalage formé par les bascules 96, 100, 104.

Ces cas sont identifiés de la manière suivante :

α) un mot de code de longueur 3,5T ou 4T dont la première transition est en milieu d'intervalle de bit correspond à l'état $Q'_1$="1" et $Q'_2=Q'_3=Q'_4$="0". Cette condition permet à elle seule d'identifier les paliers de longueur 3,5T et 4T dont la première transition arrive en milieu de l'intervalle de bit.

β) un mot de code de longueur 3T dont la première transition arrive en début d'intervalle de bit correspond à l'état $Q'_1=Q'_4$="1", $Q'_2=Q'_3$="0" et $Q_1=Q_4$="0".

γ) un mot de code de longueur 3,5T dont la première transition arrive en début d'intervalle de bit correspond à l'état : $Q'_1=Q'_4$="1", $Q'_2=Q'_3$="0", $Q_1$="1" et $Q_4$="0".

L'identification étant réalisée, la modification du train binaire par forçage à la valeur "1" des entrées $D_3$, $D_4$ et $D_5$ se fait comme suit :

a) l'entrée $D_3$ est égale à "1" si $Q'_1$="0" et $Q_2$="1" (Condition de fonctionnement du convertisseur élémentaire). Le circuit de transformation va forcer $D_3$ à la valeur "1" dans les cas α) β) et γ) décrits précédemment. On a alors $\overline{Q'_4}.\overline{Q'_3}.\overline{Q'_2}.Q'_1$="1" dans le cas α) et $Q'_4.\overline{Q'_3}.\overline{Q'_2}.Q'_1.\overline{Q_4}$="1" dans les cas β) et γ).

L'ensemble des conditions se résume par l'équation logique :

$D_3=\overline{Q'_1}.Q_2 + \overline{Q'_4}.\overline{Q'_3}.\overline{Q'_2}.Q'_1 + \overline{Q_4}.Q'_4.\overline{Q'_3}.\overline{Q'_2}.Q'_1$ ou

$D_3=\overline{Q'_1}.Q_2 + \overline{Q'_4}.\overline{Q'_3}.\overline{Q'_2}.Q'_1 + \overline{Q_4}.\overline{Q'_3}.\overline{Q'_2}.Q'_1$

b) l'entrée $D_4$ du convertisseur prend la valeur $Q_3$ dans le cas général. Le circuit de transformation force $D_4$ à la valeur "1" dans les cas β) et γ), c'est-à-dire lorsque : $Q'_4.\overline{Q'_3}.\overline{Q'_2}.Q'_1.\overline{Q_4}$="1".

L'ensemble des conditions se résume par l'équation logique :

$D_4=Q_3 + Q'_4.\overline{Q_4}.\overline{Q'_3}.\overline{Q'_2}.Q'_1$

c) l'entrée $D_5$ du convertisseur prend la valeur $Q_4$ dans le cas général. Le circuit de transformation force $D_5$ à la valeur "1" dans le cas β), c'est-à-dire lorsque :

$\overline{Q_4}.Q'_4.\overline{Q'_3}.\overline{Q'_2}.Q'_1.\overline{Q_1}$="1".

L'ensemble des conditions se résume par l'équation logique :

$D_5=Q_4 + \overline{Q_4}.Q'_4.\overline{Q'_3}.\overline{Q'_2}.Q'_1.\overline{Q_1}$

Ces équations logiques sont matérialisées par les portes 94 à 114.

Notons enfin que le circuit de transformation du train binaire décrit permet de tenir compte de l'introduction du mot de synchronisation décrit en référence à la figure 6.

**Revendications**

1. Procédé de modulation en bande de base d'un signal de données composé d'une succession de bits à une cadence T, le signal modulé comprenant une suite d'intervalles de bits à la cadence T, procédé dans lequel on marque normalement un bit du premier état logique, noté "0", par une transition en début d'un intervalle de bit et un bit de second état logique, noté "1", par une transition en milieu d'un intervalle de bit, ledit procédé étant caractérisé en ce que :

a) on marque un bit de valeur "0", s'il suit un bit non marqué de valeur "0" ou une séquence de trois bits consécutifs non marqués de valeur "1",

b) on marque un bit de valeur "1" s'il suit un bit de valeur "0" ou une séquence de trois bits consécutifs non marqués de valeur "1",

c) par exception aux règles précédentes, dans le cas où ces règles conduisent à marquer le premier bit d'une séquence, dite séquence particulière, composée de trois bits de valeur "1", suivis d'un bit de valeur "0", on code cette séquence particulière de la manière suivante ;

    c1) si le bit précédent ladite séquence particulière est un bit marqué de valeur "0", seul le troisième bit de valeur "1" de ladite séquence particulière est marqué et il l'est par une transition en milieu d'intervalle de bit,

    c2) dans les autres cas, on marque le premier bit de valeur "1" et le bit de valeur "0" de ladite séquence particulière chacun par une transition en début d'intervalle de bit.

2. Appareil de modulation pour la mise en oeuvre du procédé selon la revendication 1, comprenant un générateur d'horloges (2) délivrant un signal d'horloge H de période T et un signal d'horloge H' de période T/2, lesdits signaux d'horloges étant synchronisés ; un convertisseur (4) alimenté par le signal de données binaires SD et recevant le signal d'horloge H, ledit convertisseur délivrant deux singaux binaires $d_0$, $d_1$ notant respectivement les transitions en début et en milieu d'intervalle de bit ; et un circuit de sérialisation (6) recevant les signaux $d_0$, $d_1$ et les signaux d'horloge H et H' et délivrant le signal modulé SM, ledit appareil étant caractérisé en ce que le convertisseur (4) comprend :

- un convertisseur élémentaire comprenant un moyen de détection pour détecter et différencier les bits de valeur "0" marqués et non marqués, et un moyen de codage pour coder le bit du signal de données suivant un bit de valeur "0" détecté par le moyen de détection, ledit moyen de codage étant apte à coder ledit bit conformément au procédé,
- un circuit de transformation pour transformer la valeur d'un bit de valeur "1" en valeur "0", avant le codage dudit bit, lorsque l'une des conditions suivantes est réalisée :

a) ledit bit est le quatrième bit d'une séquence de quatre bits de valeur "1" dont seul le premier est marqué,

b) ledit bit est le deuxième bit de la séquence particulière et cette séquence suit un bit marqué de valeur "0",

c) ledit bit est le troisième bit de la séquence particulière et cette séquence suit un bit non marqué de valeur "0".

3. Appareil selon la revendication 2, caractérisé en ce que le convertisseur élémentaire comprend :
- un registre à décalage composé de cinq bascules bistables en série (8, 10, 12, 14, 16) la première bascule recevant le signal de données SD,
- une bascule bistable (18) et au moins une porte logique (20), agencés pour que ladite bascule indique, par un premier état logique, la présence d'un bit marqué de valeur "0" dans la dernière bascule (16) du registre à décalage et, par l'autre état logique, la présence d'un bit non marqué de valeur "0" dans cette bascule,
- un ensemble de portes logiques (22, 30) pour combiner les signaux délivrés par les six bascules pour produire les signaux de transition $d_0$, $d_1$.

4. Appareil selon la revendication 3, caractérisé en ce que le circuit de transformation comprend un ensemble de portes logiques (32, 40) pour forcer les entrées des deuxième, troisième et quatrième bascules (10, 12, 14) du registre à décalage à la valeur "1" lorsque les conditions de transformation sont réunies.

5. Appareil selon l'une quelconque des revendications 2 à 4, caractérisé en ce qu'il comprend un moyen (50, 52) d'insertion d'un mot de synchronisation dans le signal modulé.

6. Appareil selon la revendication 5, caractérisé en ce que le mot de synchronisation a une longueur de six intervalles de bit, ce mot étant codé par deux transitions qui sont situées en milieu des premier et sixième intervalles de bit.

7. Appareil de démodulation pour produire un signal de données à partir d'un signal modulé reçu obtenu selon le procédé de la revendication 1, ledit appareil comprenant un circuit de restitution d'horloges (59) recevant le signal modulé et produisant un signal d'horloge H de période T dont, les front montants coïncident avec le début des intervalles de bit, et un signal d'horloge H' de période T/2 synchronisé sur le signal d'horloge H ; un circuit de désérialisation (60) recevant le signal d'horloge H et le signal modulé et délivrant un signal $S_0$ indiquant la présence d'une transition en début d'un intervalle de bit et un signal $S_1$ indiquant une transition en milieu d'un intervalle de bit ; et un convertisseur (62) recevant les signaux délivrés par le circuit de désérialisation et le signal d'horloge H et produisant le signal de données binaires, ledit appareil étant caractérisé en ce que ledit convertisseur comprend :
- un convertisseur élémentaire (74) pour délivrer un bit de valeur "0" lorsque le signal $S_0$ indique une transition en début d'intervalle de bit et un bit de valeur "1" lorsque le signal $S_1$ indique une transition en milieu d'intervalle de bit, et pour forcer à la valeur "0" chaque bit de donnée qui immédiatement précède un bit marqué,
- un circuit de transformation (76) pour transformer l'état d'un bit de valeur "0" délivré par le convertisseur élémentaire en un bit de valeur "1" lorsque l'une des conditions suivantes est réalisée :

α) dans un signal modulé dont l'interfront est égal à 3,5T ou 4T, dans lequel ledit bit précède le bit associé à la transition finale de l'interfront et la transition initiale de l'interfront est en milieu de l'intervalle de bit, ledit bit est forcé à la valeur "1",

β) dans un signal modulé dont l'interfront est égal à 3T et dont la transition initiale est en début de l'intervalle de bit, les trois bits associés à cet interfront sont forcés à la valeur "1",

γ) dans un signal modulé dont l'interfront est égal à 3,5T et dont la transition initiale est en début de l'intervalle de bit, les deux bits associés aux intervalles de bits consécutifs audit intervalle de bit sont forcés à la valeur "1".

8. Appareil selon la revendication 7, caractérisé en ce que le convertisseur élémentaire comprend :
- une bascule J-K (82) recevant respectivement sur ses entrées J et K les signaux $S_1$ et $S_0$,
- une bascule bistable (84) dont l'entrée de données est reliée à la sortie de la bascule J-K,
- une autre bascule bistable (80) dont l'entrée de données reçoit un signal de transition $S_\phi$ délivré par une porte OU 78 recevant les signaux $S_0$ et $S_1$,
- une porte ET (86) dont une entrée non inverseuse est reliée à la sortie de ladite bascule et dont une entrée inverseuse est reliée à la sortie de ladite autre bascule, la sortie de cette porte constituant la sortie du convertisseur élémentaire.

9. Appareil selon la revendication 8, caractérisé en ce que le circuit de transformation comprend :
- un ensemble de trois bascule bistables (88, 90, 92) formant un premier registre à décalage à 4 étages avec ladite autre bascule (80) du convertisseur élémentaire,
- un ensemble de trois bascules bistables (96, 100, 104) formant un second registre à décalage à 4 étages avec ladite bascule (84) du convertisseur élémentaire,
- un ensemble de portes logiques pour combiner les signaux délivrés par le premier registre à décalage pour forcer une ou plusieurs entrées des bascules du second registre à décalage à la valeur "1" lorsque les conditions de transformation sont réunies.

**Claims**

1. Process for the baseband modulation of a data signal formed from a succession of bits at rate T, the modulated signal comprising a sequence of bit intervals at rate T, in which a bit of the first logic state 0 is marked by a transition at the start of a bit interval and a bit of the second logic state 1 by a transition in the centre of a bit interval, characterized in that:

a) a bit is marked with the value 0 if it follows a bit nor marked with the value 0 or a sequence of three consecutive bits not marked with the value 1,

b) a bit is marked with the value 1 if it follows a bit of value 0 or a sequence of three consecutive bits not marked with the value 1,

c) by exception to the above rules, in the case where they lead to the marking of the of the first bit of a sequence, called particular sequence, formed from three bits of value 1, followed by a bit of value 0, said particular sequence is coded in the following way:

c1) if the bit preceding said particular sequence is a marked bit of value 0, only the third bit of value 1 of said particular sequence is marked, by a bit interval centre transition,

c2) in the other cases, the first bit of value 1 is marked, as is the bit of value 0 of said particular sequence, each by a bit interval start transition.

2. Modulation apparatus for performing the process according to claim 1, comprising a clock generator (2) supplying a clock signal H of period T, whose rising fronts coincide with the start of the bit intervals of the modulated signal and a clock signal H' of period T/2 synchronized with the clock signal H; a converter (4) supplied by the binary data signal and receiving the clock signal H, said converter supplying two binary signals $d_0$, $d_1$ respectively designating the transitions at the start and centre of the bit interval, and a serialization circuit (6) receiving the signals $d_0$, $d_1$ and the clock signals H and H' and supplying the modulated signal, characterized in that the converter (4) comprises:

an elementary comprising a detection means for detecting and differentiating the marked and unmarked bits of value 0 and a coding means for coding the bit of the data signal following a bit of value 0 detected by the detection means, said coding means being able to code said bit according to the process, a transformation circuit for transforming the value of a bit of value 1 into value 0, prior to the coding of said bit, when one of the following conditions is satisfied:

a) said bit is the fourth bit of a sequence of four bits of value 1, whereof only the first is marked,

b) said bit is the second bit of the particular sequence and said sequence follows a marked bit of value 0,

c) said bit is the third bit of the particular sequence and said sequence follows an unmarked bit of value 0.

3. Apparatus according to claim 2, characterized in that the elementary converter comprises a shift register formed from five bistable flip-flops (8, 10, 12, 14, 16) in series, the first flip-flop receiving the data signal SD, a bistable flip-flop (18) and at least one logic gate (20) arranged so that said flip-flop indicates by a first logic state the presence of marked bit of 0 in the final flip-flop (16) of the shift register and by the other logic state the presence of an unmarked bit of value 0 in said flip-flop and a group of logic gates (22, 30) for combining the signal supplied by the six flip-flops for producing transition signals $d_0$, $d_1$.

4. Apparatus according to claim 3, characterized in that the transformation circuit comprises a group of logic gates (32, 40) setting the inputs of the second, third and fourth flip-flops (10, 12, 14) of the shift register to value 1, when the transformation conditions are combined.

5. Apparatus according to any one of the claims 2 to 4, characterized in that it comprises a means (50, 52) for inserting a synchronization word in the modulated signal.

6. Apparatus according to claim 5, characterized in that the synchronization word has a length of six bit intervals, said word being coded by two transitions located in the centre of the first and sixth bit intervals.

7. Demodulation apparatus for producing a data signal from a received modulated signal obtained according to the process of claim 1, said apparatus comprising a clock restoration circuit (59) receiving the modulated signal and producing a clock signal H of period T, whose rising fronts coincide with the start of the bit intervals and a clock signal H' of period T/2 synchronized with the clock signal H; a deserialization circuit (60) receiving the clock signal H' and the modulated signal and supplying a sign $S_0$ indicating the presence of a transition at the start of a bit interval and a signal $S_1$ indication a transition in the centre of a bit interval; and a converter (62) receiving the signals supplied by the deserialization circuit and the clock signal H and producing a binary data signal, wherein the converter comprises:

an elementary converter (74) for supplying a data bit of value 0, when the signal $S_0$ indicates a transition at the start of a bit interval and a data bit of value 1 when the signal $S_1$ indicates a transition in the centre of the bit interval and for setting to the value 0 each data bit immediately preceding a marked bit,

a transformation circuit (76) for transforming the state of a data bit of value 0 supplied by the elementary converter into a data bit of value of value 1 when one of the following conditions is satisfied:

$\alpha$) in a modulated signal, whereof the interfront is equal to 3.5T or 4T, in which said bit precedes the bit associated with the final transition of the interfront and the initial transition of the interfront is in the centre of the bit interval, said bit is set to the value 1,

$\beta$) in a modulated signal, whereof the interfront is equal to 3T and whereof the initial transition is at the start of the bit interval, the three bits associated with said interfront are set to value 1,

$\gamma$) in a modulated signal, whereof the interfront is equal to 3.5T and whereof the initial transition is at the start of the bit interval, the two bits associated with the consecutive intervals with respect to said bit interval are set to the value 1.

8. Apparatus according to claim 7, characterized in that the elementary converter comprises a J–K flip-flop (82) respectively receiving on its inputs J and K the signals $S_1$ and $S_0$, a bistable flip-flop (84), whose data input is connected to the output of the J–K flip-flop, another bistable flip-flop (80), whose data input receives a transition signal $S\alpha$ supplied by an OR gate receiving the signals $S_0$ and $S_1$ and an AND gate (86), whereof a non-inverting input is connected to the output of said flip-flop and whereof an inverting input is connected to the output of the other flip-flop, the output of said gate constituting the output of the elementary converter.

9. Apparatus according to claim 8, characterized in that the transformation circuit comprises a group of three bistable flip-flops (88, 90, 92) forming a first four-stage shift register with the other flip-flop (80) of the elementary converter, a group of three bistable flip-flops (96, 100, 104) forming a second four-stage shift register with said flip-flop (84) of the elementary converter and a group of logic gates for combining the signals supplied by the first shift register for setting one or more inputs of the flip-flops of the second shift register to value 1 when the transformation conditions are combined.

## Patentansprüche

1. Verfahren zur Basisbandmodulation eines Datensignals, das aus einer Folge von Bits in einem Takt T besteht, wobei das modulierte Signal eine Folge von Bitintervallen im Takt T aufweist, in welchem Verfahren man normalerweise ein Bit des ersten logischen Zustands, "0" bezeichnet, durch einen Übergang am Anfang eines Bitintervalls und ein Bit des zweiten logischen Zustands, "1" bezeichnet, durch einen Übergang in der Mitte des Bitintervalls markiert, wobei das Verfahren dadurch gekennzeichnet ist, daß:

a) man ein Bit des Wertes "0" markiert, wenn es auf ein nicht markiertes Bit des Wertes "0" oder auf eine Folge von drei nicht markierten Bits des Wertes "1" folgt,

b) man ein Bit des Wertes "1" markiert, wenn es auf ein Bit des Wertes "0" oder auf eine Folge von drei nicht markierten Bits des Wertes "1" folgt,

c) man als Ausnahme von den vorstehenden Regeln für den Fall, daß diese Regeln dazu führen, das erste Bit einer Sequenz, besondere Sequenz genannt, die aus drei Bits des Wertes "1" gefolgt von einem Bit des Wertes "0" besteht, diese besondere Sequenz auf folgende Art kodiert:

c1) wenn das der besonderen Sequenz vorangehende Bit ein markiertes Bit des Wertes "0" ist, wird nur das dritte Bit des Wertes "1" der besonderen Sequenz markiert, und es wird markiert durch einen Übergang in der Mitte des Bitintervalls,

c2) in den anderen Fällen markiert man das erste Bit des Wertes "1" und das Bit des Wertes "0" der besonderen Sequenz jeweils durch einen Übergang zu Beginn des Bitintervalls.

2. Modulationsvorrichtung zum Durchführen des Verfahrens nach Anspruch 1 mit einem Taktgenerator (2), der ein Taktsignal H der Periode T und ein Taktsignal H' der Periode T/2 abgibt, wobei die Taktsignale synchronisiert sind; einem Wandler (4), der mit dem binären Datensignal SD versorgt wird und das Taktsignal H empfängt, wobei der Wandler (4) zwei binäre Signale $d_0$, $d_1$ erzeugt, die jeweils die Übergänge zu Beginn und in der Mitte des Bitintervalls vermerken; und einen Serialisationsschaltkreis (6), der die Signale $d_0$, $d_1$ und die Taktsignale H und H' empfängt und das modulierte Signal SM abgibt, wobei die Vorrichtung dadurch gekennzeichnet ist, daß der Wandler (4) aufweist:

– einen Elementarwandler mit einer Detektiervorrichtung zum Detektieren und Unterscheiden der markierten und nicht markierten Bits vom Wert "0" und mit einer Kodiervorrichtung zum Kodieren des Bits des auf ein Bit des Wertes "0", das durch die Detektiervorrichtung detektiert wird, folgenden Datensignals, wobei die Kodiervorrichtung geeignet ist, das Bit entsprechend dem Verfahren zu kodieren,

– einen Transformationsschaltkreis zum Transformieren des Wertes eines Bits vom Wert "1" in den Wert "0" vor der Kodierung des Bits, wenn eine der folgenden Bedingungen erfüllt ist:

a) das Bit ist das vierte Bit einer Folge von vier Bits mit dem Wert "1", von denen nur das erste markiert ist,

b) das Bit ist das zweite Bit der besonderen Sequenz und diese Sequenz folgt einem markierten Bit des Wertes "0",

c) das Bit ist das dritte Bit der besonderen Sequenz und diese Sequenz folgt einem nicht markierten Bit des Wertes "0".

3. Vorrichtung nach Anspruch 2, dadurch gekennzeichnet, daß der Elementarwandler aufweist:
- ein aus fünf bistabilen, in Serie geschalteten Kippschaltungen (8, 10, 12, 14, 16) bestehendes Schieberegister, wobei die erste Kippschaltung das Datensignal SD empfängt,
- eine bistabile Kippschaltung (18) und wenigstens ein logisches Gatter (20), die so angeordnet sind, daß das Gatter durch einen ersten logischen Zustand die Anwesenheit eines markierten Bits mit dem Wert "0" in der letzten Kippschaltung (16) des Schieberegisters und durch den anderen logischen Zustand die Anwesenheit eines nicht markierten Bits mit dem Wert "0" in dieser Kippschaltung angibt,
- eine Anordnung logischer Gatter (22, 30) zum Kombinieren der durch die sechs Kippschaltungen erzeugten Signale zum Erzeugen der Übergangssignale $d_0$, $d_1$.

4. Vorrichtung nach Anspruch 3, dadurch gekennzeichnet, daß der Transformationsschaltkreis eine Anordnung logischer Gatter (32, 40) aufweist, um die Eingänge der zweiten, dritten und vierten Kippschaltung (10, 12, 14) des Schieberegisters auf den Wert "1" zu bringen, sobald die Transformationsbedingungen eingetreten sind.

5. Vorrichtung nach einem der Ansprüche 2 bis 4, dadurch gekennzeichnet, daß sie eine Vorrichtung (50, 52) zum Einsetzen eines Synchronisationswortes in das modulierte Signal aufweist.

6. Vorrichtung nach Anspruch 5, dadurch gekennzeichnet, daß das Synchronisationswort eine Länge von sechs Bitintervallen besitzt, wobei dieses Wort durch zwei Übergänge kodiert wird, die sich in der Mitte des ersten und des sechsten Bitintervalls befinden.

7. Demodulationsvorrichtung zum Erzeugen eines Datensignals ausgehend von einem empfangenen, modulierten, nach dem Verfahren nach Anspruch 1 erhaltenen Signal, wobei diese Vorrichtung aufweist: einen Taktwiederherstellungsschaltkreis (59), der das modulierte Signal empfängt und ein Taktsignal H der Periode T, dessen aufsteigende Flanken mit dem Beginn der Bitintervalle zusammenfallen, und ein Taktsignal H' der Periode T/2 erzeugt, das mit dem Taktsignal H synchronisiert ist; einen Entserialisierungsschaltkreis (60), der das Taktsignal H und das modulierte Signal empfängt und ein Signal $S_0$, das die Anwesenheit eines Übergangs am Beginn eines Bitintervalls anzeigt und ein Signal $S_1$ abgibt, das einen Übergang in der Mitte eines Bitintervalls anzeigt; und einen Wandler (62), der die vom Entserialisierungsschaltkreis abgegebenen Signale und das Taktsignal H empfängt und das binäre Datensignal erzeugt, wobei die Vorrichtung dadurch gekennzeichnet ist, daß der Wandler aufweist:
- einen Elementarwandler (74) zum Abgeben eines Bits vom Wert "0", falls das Signal $S_0$ einen Übergang am Beginn eines Bitintervalls anzeigt, und eines Bits vom Wert "1", falls das Signal $S_1$ einen Übergang in der Mitte eines Bitintervalls anzeigt, und zum Einstellen auf den Wert "0" jedes Datenbits, das unvermittelt einem markierten Bit folgt,
- einen Transformationsschaltkreis (76), zum Transformieren des Zustands eines Bits vom Wert "0", das vom Elementarwandler abgegeben wird, in ein Bit vom Wert "1", falls eine der folgenden Bedingungen eintrifft:

    α) in einem modulierten Signal, dessen Zwischenflanke gleich 3,5 T oder 4 T ist, in dem das Bit dem mit dem Schlußübergang der Zwischenflanke verbundenen Bit vorangeht und der Anfangsübergang der Zwischenflanke in der Mitte des Bitintervalls ist, ist das Bit auf den Wert "1" gesetzt,

    β) in einem modulierten Signal, dessen Zwischenflanke 3 T ist und dessen Anfangsübergang am Beginn des Bitintervalls ist, sind die drei mit dieser Zwischenflanke verbundenen Bits auf den Wert "1" gesetzt,

    γ) in einem modulierten Signal, dessen Zwischenflanke gleich 3,5 T ist und dessen Anfangsübergang am Beginn des Bitintervalls ist, sind die zwei mit den Zwischenflanken verbundenen Bits der dem Bitintervall folgenden Bits auf den Wert "1" gesetzt.

8. Vorrichtung nach Anspruch 7, dadurch gekennzeichnet, daß der Elementarwandler aufweist:
- ein J–K-Flip-Flop (82), das auf seinen Eingängen J und K jeweils die Signale $S_1$ und $S_0$ empfängt,
- eine bistabile Kippschaltung (84), deren Dateneingang mit dem Ausgang des J–K-Flip-Flops verbunden ist,
- eine weitere bistabile Kippschaltung (80), deren Dateneingang ein Übergangssignal $S_0$ empfängt, das von einem die Signale $S_0$ und $S_1$ erhaltenen ODER-Gatter (78) abgegeben wird,
- ein UND-Gatter (86), bei dem ein nicht invertierender Eingang mit dem Ausgang dieser Kippschaltung und ein invertierender Eingang mit dem Ausgang der anderen Kippschaltung verbunden ist, wobei der Ausgang dieses Gatters den Ausgang des Elementarwandlers bildet.

9. Vorrichtung nach Anspruch 8, dadurch gekennzeichnet, daß der Transformationsschaltkreis aufweist:
- eine Anordnung von drei bistabilen Kippschaltungen (88, 90, 92), die ein erstes, vierstufiges Schieberegister mit der anderen Kippschaltung (80) des Elementarwandlers bilden,
- eine Anordnung von drei bistabilen Kippschaltungen (96, 100, 104), die ein zweites, vierstufiges Schieberegister mit der Kippschaltung (84) des Elementarwandlers bilden,
- eine Anordnung von logischen Gattern zum Kombinieren der vom ersten Schieberegister abgegebenen Signale, um einen oder mehrere Eingänge der Kippschaltungen des zweiten Schieberegisters auf den Wert "1" zu setzen, falls die Transformationsbedingungen zutreffen.

FIG. 1a

FIG. 1b

FIG. 1c

FIG. 1d

FIG. 1e

FIG. 1f

FIG. 1g

FIG. 1h

FIG. 1i

FIG. 2

FIG. 3

FIG. 8

FIG. 4

EP 0 211 757 B1

FIG. 5

FIG. 6

FIG. 7

FIG. 9

EP 0 211 757 B1